(19) **Europäisches Patentamt European Patent Office Office européen des brevets**

(11) **EP 2 605 292 B1**

(12) **EUROPEAN PATENT SPECIFICATION**

(45) Date of publication and mention
of the grant of the patent:
**26.02.2020 Bulletin 2020/09**

(51) Int Cl.:
*H01L 31/05* [(2014.01)]   *H01L 31/02* [(2006.01)]
*C23F 13/20* [(2006.01)]

(21) Application number: **11816580.2**

(22) Date of filing: **09.08.2011**

(86) International application number:
**PCT/KR2011/005784**

(87) International publication number:
**WO 2012/020964 (16.02.2012 Gazette 2012/07)**

(54) **CORROSION-RESISTANT PHOTOVOLTAIC MODULE**

KORROSIONSBESTÄNDIGES PHOTOVOLTAIKMODUL

MODULE PHOTOVOLTAÏQUE RÉSISTANT À LA CORROSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.08.2010 KR 20100077246**

(43) Date of publication of application:
**19.06.2013 Bulletin 2013/25**

(73) Proprietor: **Korea University Research and Business Foundation**
**Seongbuk-gu**
**Seoul 136-713 (KR)**

(72) Inventors:
• **KIM, Dong Hwan**
**Seoul 140-751 (KR)**
• **TARK, Sung Ju**
**Seoul 139-224 (KR)**
• **KANG, Min Gu**
**Seoul 153-860 (KR)**
• **PARK, Sung Eun**
**Busan 608-814 (KR)**

(74) Representative: **Kador & Partner PartG mbB**
**Corneliusstraße 15**
**80469 München (DE)**

(56) References cited:
**JP-A- S62 297 479     JP-A- 2004 192 954**
**KR-A- 20030 095 243     KR-A- 20050 099 553**
**KR-A- 20080 078 869     KR-A- 20100 043 473**
**US-A1- 2007 144 578**

## Description

### TECHNICAL FIELD

The present invention relates to a corrosion-resistant photovoltaic module, and more particularly to a corrosion-resistant photovoltaic module including an anode for cathodic protection attached to an interconnector ribbon.

### BACKGROUND

Photovoltaic cell is a semiconductor device that converts light energy into electric energy using the photoelectric effect. The photovoltaic cell utilizing solar energy has more attention recently as viable alternative energy sources and global market scale thereof is rapidly increased due to its low cost.

Actual required voltage is in the tens or even hundreds of V or higher, but voltage generated from one-cell is 0.5V which is very small value. Thus, a plurality of photovoltaic cells are used by being connected in a serial or parallel. A part connecting between such cells is called as an interconnector ribbon and structure in which such cells are connected to have electromotive force is called as a photovoltaic module.

However, when the photovoltaic module is exposed to an external environment for a long period of time, the interconnector ribbon gets oxidized and corroded due to various reasons such as moisture and the like and eventually causes a significant increase of resistance which results in deteriorating the efficiency of the photovoltaic cell.

A connective part between the interconnector ribbon and the photovoltaic cell becomes oxidized due to external temperature, humidity and the like. It may cause corrosion of the interconnector ribbon, increase of degradation, and reduction of voltage and current due to increase of serial resistance of the photovoltaic cell.

KR 1994-7002010 discloses a protective coating of an inorganic material having corrosion resistance in order to prevent the corrosion of the photovoltaic cell.

KR 2010-0134882 discloses two protective layers having two different properties to improve moisture resistance and eventually to prevent the corrosion of the photovoltaic cell.

However, such technologies have drawbacks in increase of manufacturing cost and manufacturing time since additional processes and materials are required. Document US 2007/0144578 A1 discloses a photovoltaic module comprising at least one photovoltaic cell and an interconnector ribbon.

### SUMMARY OF THE INVENTION

The inventors have completed the present invention with an effort to develop a photovoltaic module which can solve the above-mentioned problems associated with the conventional technologies.

It is an object of the present invention to provide a corrosion-resistant photovoltaic module comprising an interconnector ribbon connecting photovoltaic cells and an anode for cathodic protection attached to the interconnector ribbon to prevent corrosion of a connective part between the photovoltaic cells.

In order to achieve the above-mentioned object, there is provided a corrosion-resistant photovoltaic according to the independent claim 1.

In a corrosion-resistant photovoltaic module according to an embodiment of the present invention, the interconnector ribbon may be at least one chosen from a Cu electrode coated with Sn-Pb alloy, a Cu electrode coated with Sn, a Cu electrode coated with Sn-Pb-Ag alloy, a Cu electrode coated with Sn-Ag alloy, and a Cu electrode coated with Sn-Ag-Cu alloy.

In a corrosion-resistant photovoltaic module according to an embodiment of the present invention, the anode for cathodic protection may be sacrificial anode.

In a corrosion-resistant photovoltaic module according to an embodiment of the present invention, the anode for cathodic protection is a metal having ionization tendency which is higher than the interconnector ribbon metal.

In a corrosion-resistant photovoltaic module according to an embodiment of the present invention, the anode for cathodic protection may be at least one chosen from Mg, Mg alloy, Al, Al alloy, Zn, and Zn alloy.

In a corrosion-resistant photovoltaic module according to an embodiment of the present invention, size of the anode for cathodic protection may be larger than that of the cathode.

In a corrosion resistant photovoltaic module according to an embodiment of the present invention, the anode for cathodic protection may be positioned at a relatively high current conductor in the photovoltaic cells.

In a corrosion-resistant photovoltaic module according to an embodiment of the present invention, the anode for cathodic protection is positioned at bus ribbon or bus bar.

According to another aspect not forming part of the present invention, there is provided a method for preventing corrosion of a photovoltaic module by preventing corrosion of the interconnector ribbon as a method for preventing corrosion of a photovoltaic module including at least two photovoltaic cells and an interconnector ribbon connecting between the photovoltaic cells.

According to the present invention, it can prevent an increase of serial resistance at a connective part between the ribbon and the cell and can significantly reduce the degradation of efficiency by preventing the corrosion of the interconnector ribbon caused due to the external environment. In addition, the life of the photovoltaic module can be extended

## BRIEF DESCRIPTION OF DRAWINGS

FIG. 1 is a view illustrating the structure of a photovoltaic module.

FIG. 2 is a front view (a), a plan view (b) and a rear view of the photovoltaic cells connected with an interconnector ribbon.

FIG. 3 is a diagram of a photovoltaic module including photovoltaic cells connected with an interconnector ribbon.

FIG. 4 illustrates a position to which an anode for cathodic protection can be attached on the interconnector ribbon in the structure of FIG. 3.

FIG. 5 illustrates a photovoltaic cell prepared according to an embodiment of the present invention. The left view is the structure without an anode for cathodic protection and the light view is that with an anode for cathodic protection.

FIG. 6 illustrates gradual corrosion of an anode for cathodic protection over time.

FIG. 7 illustrates graphs comparing efficiencies of photovoltaic cells with and without an anode for cathodic protection (left: Example, right: Comparison Example).

FIG. 8 illustrates graphs comparing open current voltages (Voc) of photovoltaic cells with and without an anode for cathodic protection (left: Example, right: Comparison Example).

FIG. 9 illustrates graphs comparing short current (Jsc) of photovoltaic cells with and without an anode for cathodic protection (left: Example, right: Comparison Example).

FIG. 10 illustrates graphs comparing fill factors (FF) of photovoltaic cells with and without an anode for cathodic protection (left: Example, right: Comparison Example).

FIG. 11 illustrates graphs comparing serial resistances (Rs) of photovoltaic cells with and without an anode for cathodic protection (left: Example, right: Comparison Example).

FIG. 12 illustrates graphs of changes in efficiencies of photovoltaic cells with and without an anode for cathodic protection 144 hours later after salt spray (NGSA: Example, NGNSA: Comparison Example).

FIG. 13 illustrates graphs of open current voltage of photovoltaic cells with and without an anode for cathodic protection 144 hours later after salt spray (NGSA: Example, NGNSA: Comparison Example).

FIG. 14 illustrates graphs of short currents of photovoltaic cells with and without an anode for cathodic protection 144 hours later after salt spray (NGSA: Example, NGNSA: Comparison Example).

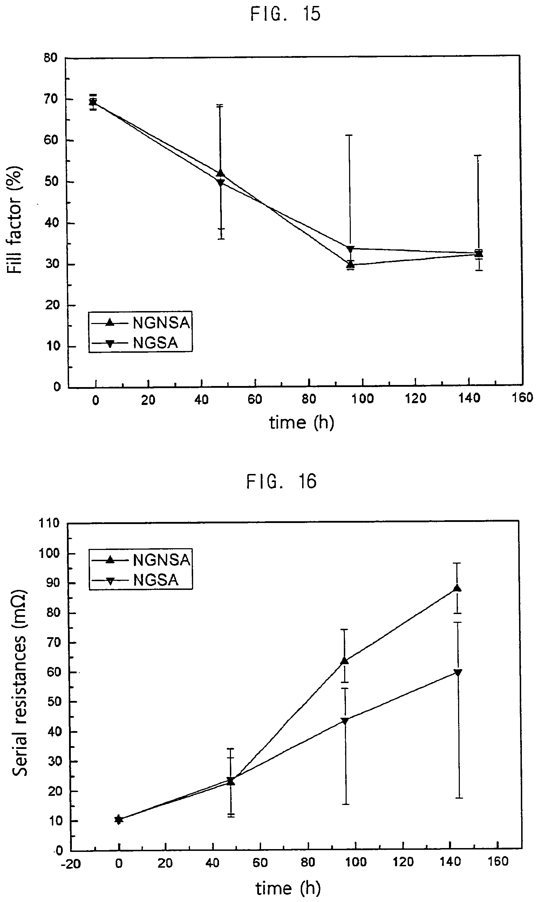

FIG. 15 illustrates graphs of fill factor of photovoltaic cells with and without an anode for cathodic protection 144 hours later after salt spray (NGSA: Example, NGNSA: Comparison Example).

FIG. 16 illustrates graphs of serial resistances of photovoltaic cells with and without an anode for cathodic protection 144 hours later after salt spray (NGSA: Example, NGNSA: Comparison Example).

## DETAILED DESCRIPTION OF THE INVENTION

Throughout the description of the present invention, when describing a certain technology is determined to evade the point of the present invention, the pertinent detailed description will be omitted.

According to the present invention, there is provided a corrosion-resistant photovoltaic module including at least one anode for cathodic protection attached to the interconnector ribbon in the photovoltaic module comprising at least two photovoltaic cells and interconnector ribbon connecting between the photovoltaic cells.

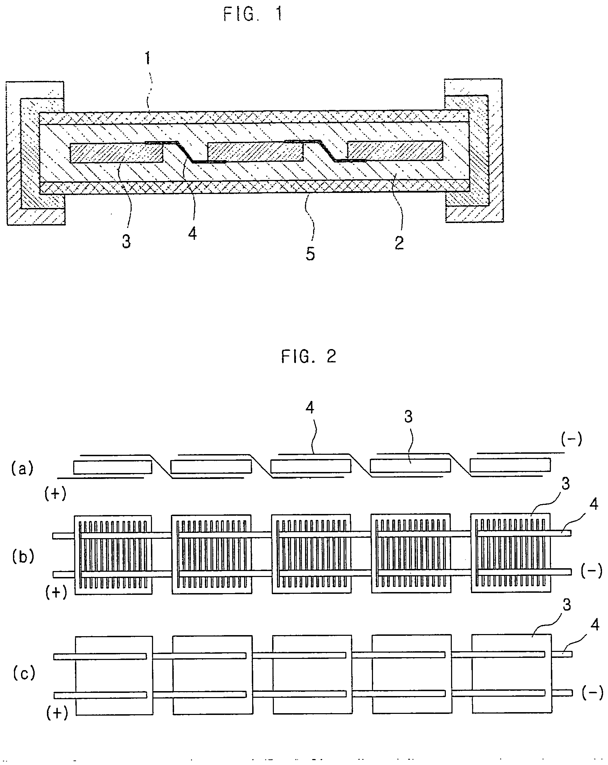

A photovoltaic system is configured with photovoltaic cell, photovoltaic module, photovoltaic panel, photovoltaic array, power conditioning system (PCS), and storage device, etc. The photovoltaic module receives the light and converts it into electricity. As shown in FIG. 1 illustrating the structure of a photovoltaic module, the photovoltaic module generally includes surface material (tempered glass) 1, filler (EVA) 2, photovoltaic cell 3, interconnector ribbon connecting between cells 4, and surface material (tedra) 5.

FIG. 2 illustrates a front view (a), a plan view (b) and a rear view of the structure of photovoltaic cells connected with an interconnector ribbon. The photovoltaic module includes a plurality of the photovoltaic cells 3 and interconnector ribbons 4 connecting the photovoltaic cells 3 at the top and the bottom.

The interconnector ribbon 4 connects between the photovoltaic cells 3 in the photovoltaic module. The interconnector ribbon 4 is usually a metallic material coated with Pb but it is not limited thereto. According to an embodiment of the present invention, the interconnector ribbon 4 may be at least one chosen from a Cu electrode coated with Sn-Pb alloy, a Cu electrode coated with Sn, a Cu electrode coated with Sn-Pb-Ag alloy, a Cu electrode coated with Sn-Ag alloy, and a Cu electrode coated with Sn-Ag-Cu alloy.

The Pb component of a connective part between the interconnector ribbon and the photovoltaic cell becomes oxidized into PbO when it reacts with oxygen in the air and further reacts with chlorine to generate $PbCl_2$ when a chlorine component exists. The result $PbCl_2$ converts to porous $PbCO_3$ and corrosion will be eventually caused since it is not stable in high humidity air containing carbon dioxide. Then, an oxidized layer may be formed on the surface of the Sn-Pb alloy and such processes may then repeat until the Sn-Pb alloy is removed due to the corrosion. Such reactions are shown in the following equations 1, 2 and 3.

$$Pb + \frac{1}{2} O_2 \rightarrow PbO \qquad (1)$$

$$\text{(metal)(air)}$$

$$PbO + 2HCl \rightarrow PbCl_2 + H_2O \qquad (2)$$

$$PbCl_2 + CO_2 + H_2O \rightarrow PbCO_3 + 2HCl \qquad (3)$$

A connective part between the interconnector ribbon and the photovoltaic cell becomes oxidized due to external temperature, humidity and the like as shown above. It thus causes corrosion of the interconnector ribbon, increase of degradation, and reduction of voltage and current due to increase of serial resistance of the photovoltaic cell.

In order to prevent such problems, is there provided a corrosion-resistant photovoltaic module including an anode for cathodic protection attached to the interconnector ribbon.

The anode for cathodic protection used in the present invention is collectively referred to as an anode used for preventing the corrosion. In a corrosion-resistant photovoltaic module according to an embodiment of the present invention, the anode for cathodic protection may be a sacrificial anode.

Corrosion prevention using an anode for cathodic protection is the one used for the principle of galvanic corrosion. The galvanic corrosion is that when dissimilar metals are immersed in a solution, it results in the potential difference between the dissimilar metals and electrons transfer between the dissimilar metals. It further leads to reducing the corrosion of the metal having higher potential and accelerating that of the other metal having lower potential. That is, one metal is acting as anode and the other is acting as cathode.

Corrosion prevention using an anode for cathodic protection of the present invention uses potential difference between the interconnector ribbon metal and the metal used as an anode for cathodic protection. Electrons, generated when the metal used as an anode for cathodic protection, which has relatively higher ionization tendency, is first ionized, move to the interconnector ribbon metal to prevent ionization at the surface of the interconnector ribbon by depolarizing potential into the protective potential at the cathode.

Accordingly, in a corrosion-resistant photovoltaic module according to an embodiment of the present invention, it is appropriated that the anode for cathodic protection may be a metal having higher ionization tendency that the interconnector ribbon.

In addition, in a corrosion-resistant photovoltaic module according to an embodiment of the present invention, the anode for cathodic protection may be at least one chosen from Mg alloy, Mg, Al alloy, Al, Zn alloy, and Zn

The anode for cathodic protection may be any metal having higher ionization tendency than the interconnector ribbon, preferably Zn, Zn alloy (Zn-Al-Si system), Al, Al alloy (Al-Zn-In system, Al-Zn-In-Si system, Al-Zn-In-Mg-Ca system), Mg, or Mg alloy (Mg-Al-Zn-Mn system), etc., but it is not limited thereto.

Since the metal used as an anode for cathodic protection has higher ionization tendency than the interconnector ribbon metal due to lower surface potential, the metal used as an anode for cathodic protection is first corroded, resulting in prevention of the interconnector ribbon metal.

Size of the anode for cathodic protection used in the present invention may be larger than that of the cathode. The anode for cathodic protection prevents corrosion of the cathode by being corroded first instead of the cathode and thus, the anticorrosion efficiency is proportional to the size. That is, the larger size of the anode for cathodic protection is, the higher the anticorrosion efficiency becomes.

Further, it is appropriated that the anode for cathodic protection be positioned at the part having higher current, preferably at bus ribbon, or bus bar of a photovoltaic cell in order to prevent the corrosion of the interconnector ribbon.

The current generated from one photovoltaic cell transmits through the bus bar and the interconnector ribbon directly in contact with the bus bar. The structure of each photovoltaic cell includes 2 or 3 bus bars to facilitate the collection of current in a large area of the photovoltaic cell. The current generated from each photovoltaic cell flows between photovoltaic cells by being divided into 2 or 3 parts and all currents are collected through bus ribbon, which is not directly in contact with the cells, to increase the current at that part.

Since this part is corroded first compared to the rest parts, it is appropriated that the anode for cathodic protection be positioned at the part having higher current like bus ribbon or bus bar.

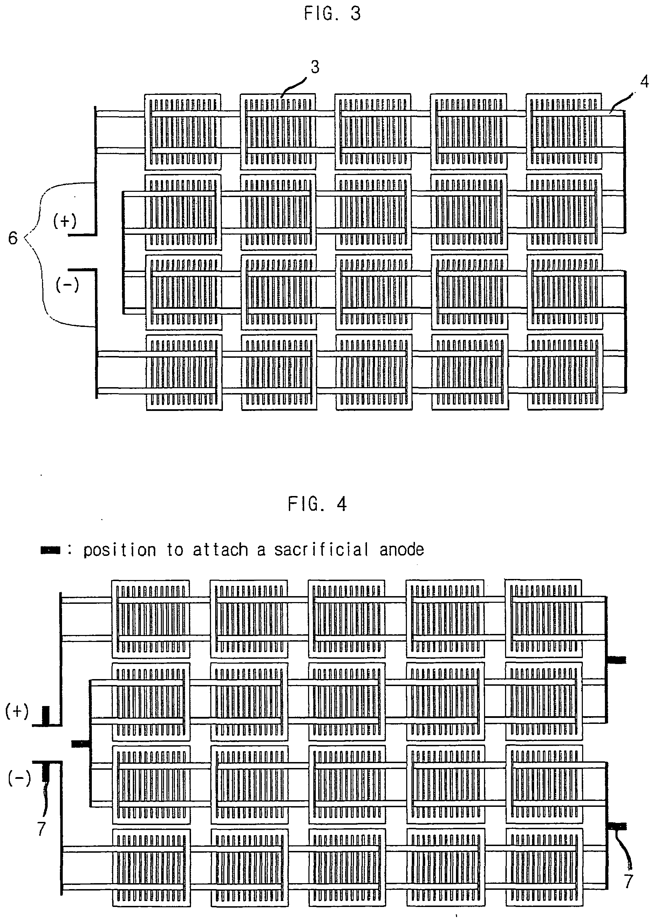

FIG. 3 is a diagram of a photovoltaic module. The interconnector ribbon 4, connecting the photovoltaic cells 2 positioned at the top and the bottom, is connected in a serial or parallel to a bus ribbon 6 which is connected to an external terminal.

FIG. 4 illustrates a view in which an anode for cathodic protection 7 is attached to the photovoltaic module as mentioned above. The anode for cathodic protection 7 is attached on the interconnector ribbon 4 of the photovoltaic module. It may be attached anywhere, preferably a location easy to observe the degree of corrosion and easy to be replaced when the corrosion of the anode for cathodic protection is severely advanced. The anode for cathodic protection 7 is attached to the bus bar in FIG. 4 as an embodiment of the present invention.

Hereinafter, although more detailed descriptions will be given by examples, those are only for explanation and there is no intention to limit the invention.

**Examples 1-15**

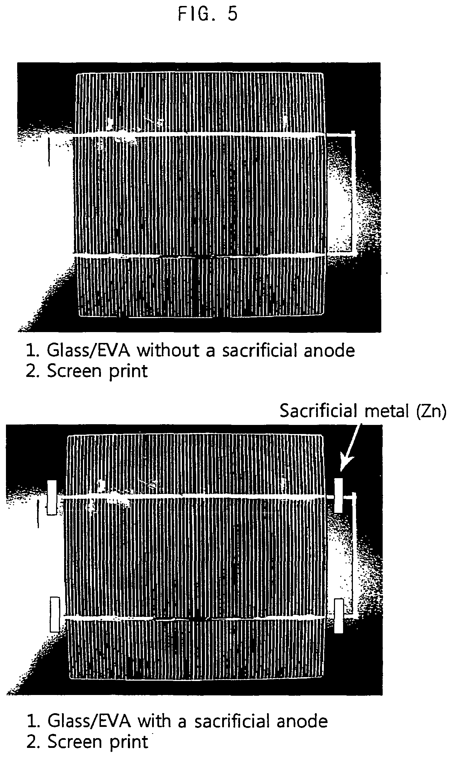

Photovoltaic cells with and without an anode for cathodic protection were tested. FIG. 5 shows a photovoltaic module without a sacrificial metal (an anode for cathodic protection) (left, Comparison Example) and a photovoltaic module with a sacrificial metal (an anode for cathodic protection) (right, Example). Each module was prepared using screen-printing process.

15 modules were prepared in each for Comparison Examples and Examples. Each module was exposed to harsher condition than the environment where a photovoltaic cell is usually exposed to cause corrosion and degradation of the properties of the photovoltaic cell electrode. Degree of corrosion and properties (efficiency, open current voltage, short current, fill factor, serial resistance) of the interconnector ribbon were determined under the condition of temperature at 45 °C, 65 °C and 85 °C and relative humidity of 85%.

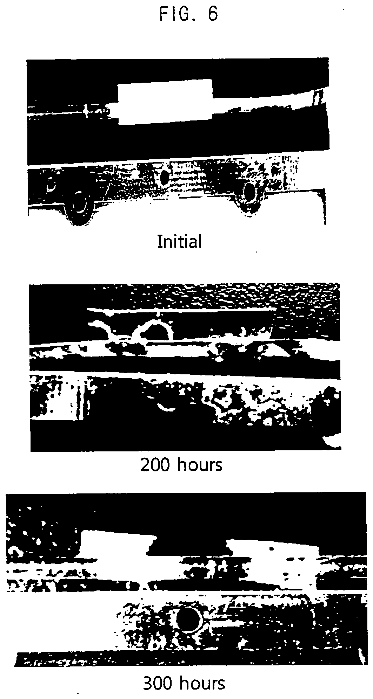

FIG. 6 illustrates gradual corrosion of an anode for cathodic protection over time when it is exposed to such harsh conditions.

An initial value of each module for various properties was measured and then changed values were measured after 300 to 2000 hours at an interval of 50-100 hours.

Properties including efficiency of each photovoltaic cell were determined by the following processes.

After connecting each electrode of the photovoltaic module, a current value was measured at the condition of AM 1.5G of solar spectrum and voltage of from -1V to IV. Values for short current (Jsc), open current voltage (Voc), fill factor were determined using Light I-V curve data of the photovoltaic cell.

Rates of changes (%) of the photovoltaic cells determined under the above-mentioned conditions are summarized in the following Table 1.

**Table 1**

| Example | temp/ humidity | Initial value | 300 hr | 600 hr | 900 hr | 1200 hr | 1500 hr | 1800 hr | 2000 hr | rate of change |
|---|---|---|---|---|---|---|---|---|---|---|
| Exam. 1 | 85/85 | 14.23 | 13.18 | 13.05 | 12.24 | 11.15 | 10.28 | 9.56 | 9.04 | -36.5% |
| Exam. 2 | 65/85 | 14.26 | 13.47 | 13.06 | 13.60 | 13.47 | 13.36 | 13.00 | 12.85 | -9.9% |
| Exam. 3 | 45/85 | 14.11 | 13.60 | 13.71 | 13.79 | 13.76 | 13.75 | 13.64 | 13.34 | -5.4% |
| Comp. Exam. 1 | 85/85 | 14.31 | 12.80 | 12.25 | 9.77 | 8.08 | 6.99 | 6.18 | 5.97 | - 58.3% |
| Comp. Exam. 2 | 65/85 | 14.41 | 13.73 | 13.82 | 13.74 | 13.61 | 13.23 | 13.16 | 12.94 | - 10.2% |
| Comp. Exam. 3 | 45/85 | 14.41 | 13.93 | 14.11 | 14.15 | 14.14 | 13.97 | 13.75 | 13.76 | -4.5% |

Referring to Table 1, the efficiency of the photovoltaic cell in Example 1, in which the anode for cathodic protection (sacrificial anode) was attached, was decreased by 36.5% under 85/85 condition (85°C temperature and 85% relative humidity), while that in Comparison Example 1, in which the anode for cathodic protection (sacrificial anode) was not attached, was decreased by 58.3%. It is noted that the presence of the anode for cathodic protection has a significant impact in the efficiency of the photovoltaic cell.

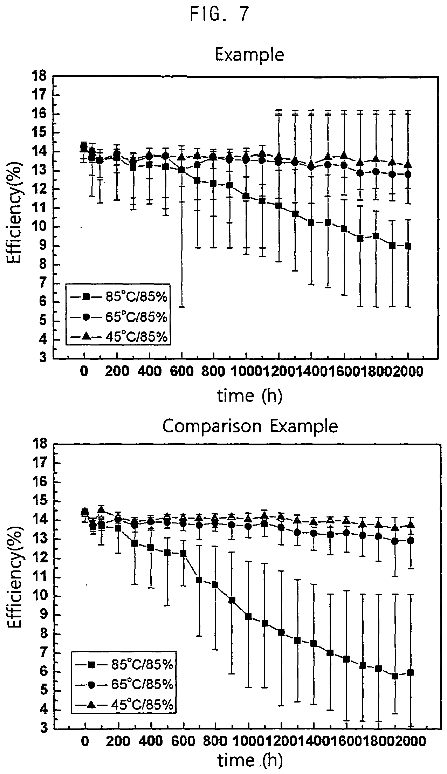

Referring to FIG. 7, it is noted that the degradation of the efficiency under the 85°C/85% condition is higher than those under 45°C/45% and 65°C/65% conditions. The degradation in the efficiency of the photovoltaic cell is significantly reduced under the 85 °C/85% condition when the anode for cathodic protection is attached (left), compared to when the anode for cathodic protection is not attached (right).

Open current voltages (Voc) of the photovoltaic cells determined under the above-mentioned conditions are summarized in the following Table 2.

**Table 2**

|  | temp/ humidity | Initial value | 300 hr | 600 hr | 900 hr | 1200 hr | 1500 hr | 1800 hr | 2000 hr | rate of change |
|---|---|---|---|---|---|---|---|---|---|---|
| Exam. 4 | 85/85 | 0.584 | 0.566 | 0.571 | 0.569 | 0.563 | 0.567 | 0.564 | 0.559 | -4.3% |
| Exam. 5 | 65/85 | 0.588 | 0.570 | 0.565 | 0.569 | 0.568 | 0.572 | 0.569 | 0.569 | -3.2% |
| Exam. 6 | 45/85 | 0.584 | 0.570 | 0.572 | 0.573 | 0.569 | 0.574 | 0.573 | 0.567 | -2.9% |
| Comp. Exam. 4 | 85/85 | 0.577 | 0.563 | 0.566 | 0.563 | 0.554 | 0.553 | 0.559 | 0.551 | -4.4% |
| Comp. Exam. 5 | 65/85 | 0.580 | 0.568 | 0.571 | 0.569 | 0.567 | 0.565 | 0.574 | 0.567 | -2.2% |
| Comp. Exam. 6 | 45/85 | 0.579 | 0.571 | 0.573 | 0.573 | 0.571 | 0.573 | 0.574 | 0.570 | -1.5% |

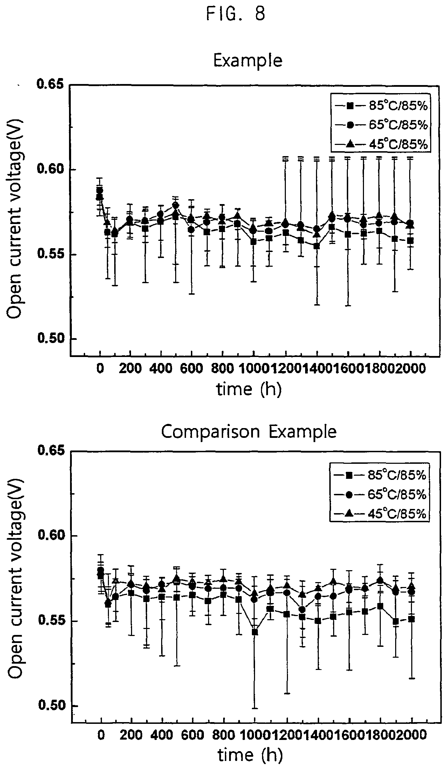

Referring to Table 2, the open current voltage of the photovoltaic cell in Example 4, in which the anode for cathodic protection (sacrificial anode) was attached, was decreased by 4.3%, while that in Comparison Example 4, in which the anode for cathodic protection (sacrificial anode) was not attached, was decreased by 4.4%. The result is shown in FIG. 8.

Referring to FIG. 8, it is noted that the open current voltage of the photovoltaic cell is highly maintained under the 85°C/85% condition when the anode for cathodic protection is attached (left), compared to when the anode for cathodic protection is not attached (right).

Short currents (Jsc) (mA/cm$^2$) of the photovoltaic cells determined under the above-mentioned conditions are summarized in the following Table 3.

**Table 3**

|  | temp/humidity | Initial value | 300 hr | 600 hr | 900 hr | 1200 hr | 1500 hr | 1800 hr | 2000 hr | rate of change |
|---|---|---|---|---|---|---|---|---|---|---|
| Exam. 7 | 85/85 | 34.6 | 34.7 | 34.8 | 35.1 | 35.1 | 35.0 | 34.9 | 34.9 | 1.1% |
| Exam. 8 | 65/85 | 34.3 | 34.3 | 34.5 | 35.0 | 35.2 | 35.4 | 35.3 | 35.4 | 3.1% |
| Exam. 9 | 45/85 | 34.3 | 34.7 | 34.8 | 35.1 | 35.4 | 35.6 | 35.5 | 35.6 | 4.0% |
| Comp. Exam. 7 | 85/85 | 35.3 | 34.9 | 34.9 | 34.1 | 33.1 | 31.8 | 30.0 | 31.0 | -12.3% |
| Comp. Exam. 8 | 65/85 | 35.2 | 34.6 | 34.5 | 35.0 | 35.3 | 35.6 | 35.0 | 35.5 | 0.8% |
| Comp. Exam. 9 | 45/85 | 35.4 | 34.9 | 34.8 | 35.4 | 35.8 | 36.0 | 35.3 | 35.9 | 1.6% |

Referring to Table 3, the short current of the photovoltaic cell in Example 7, in which the anode for cathodic protection (sacrificial anode) was attached, was increased by 1.1% under 85/85 condition (85 °C temperature and 85% relative humidity), while that in Comparison Example 7, in which the anode for cathodic protection (sacrificial anode) was not attached, was decreased by 12.3%. It is noted that the presence of the anode for cathodic protection has a significant impact in the short current of the photovoltaic cell.

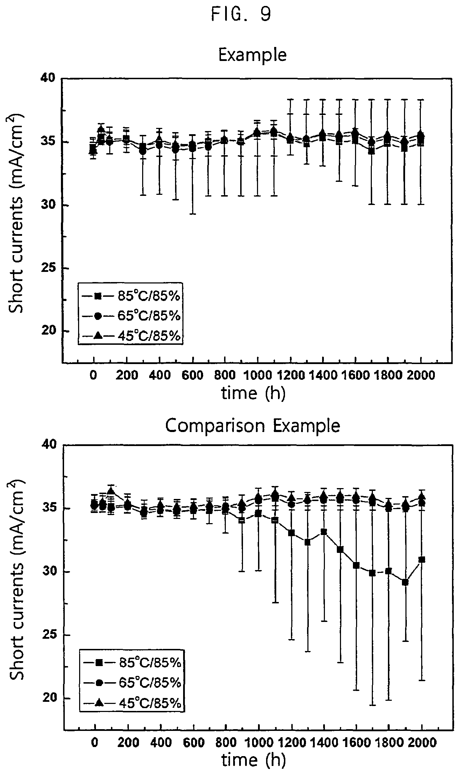

Referring to FIG. 9, it is noted that the degradation in the short current under the 85°C/85% condition is higher than those under 45°C/45% and 65°C/65% conditions. It is noted that the degradation in the short current of the photovoltaic cell is significantly increased under the 85°C/85% condition when the anode for cathodic protection is not attached (right), while any degradation in the short current is not shown when the anode for cathodic protection is attached (left).

Fill factors (%) of the photovoltaic cells determined under the above-mentioned conditions are summarized in the following Table 4.

**Table 4**

|  | temp/ humidity | Initial value | 300 hr | 600 hr | 900 hr | 1200 hr | 1500 hr | 1800 hr | 2000 hr | rate of change |
|---|---|---|---|---|---|---|---|---|---|---|
| Exam. 10 | 85/85 | 70.5 | 67.2 | 65.7 | 61.4 | 56.3 | 51.7 | 48.5 | 46.2 | 34.5% |
| Exam. 11 | 65/85 | 70.8 | 68.9 | 66.6 | 68.3 | 67.4 | 66.0 | 64.7 | 63.9 | -9.7% |
| Exam. 12 | 45/85 | 70.5 | 68.9 | 68.8 | 68.6 | 68.3 | 67.3 | 66.9 | 66.0 | -6.4% |
| Comp. Exam. 10 | 85/85 | 70.2 | 65.1 | 62.0 | 50.7 | 43.7 | 39.4 | 36.5 | 34.6 | - 50.7% |
| Comp. Exam. 11 | 65/85 | 70.6 | 69.8 | 69.5 | 69.0 | 68.0 | 65.7 | 65.6 | 64.3 | -8.9% |
| Comp. Exam. 12 | 45/85 | 70.4 | 70.0 | 70.0 | 69.7 | 69.2 | 67.7 | 67.8 | 67.1 | -4.7% |

Referring to Table 4, the fill factor of the photovoltaic cell in Example 10, in which the anode for cathodic protection (sacrificial anode) was attached, was decreased by 34.5% under 85/85 condition (85°C temperature and 85% relative humidity), while that in Comparison Example 10, in which the anode for cathodic protection (sacrificial anode) was not attached, was decreased by 50%. It is noted that the presence of the anode for cathodic protection has a significant impact in the fill factor of the photovoltaic cell.

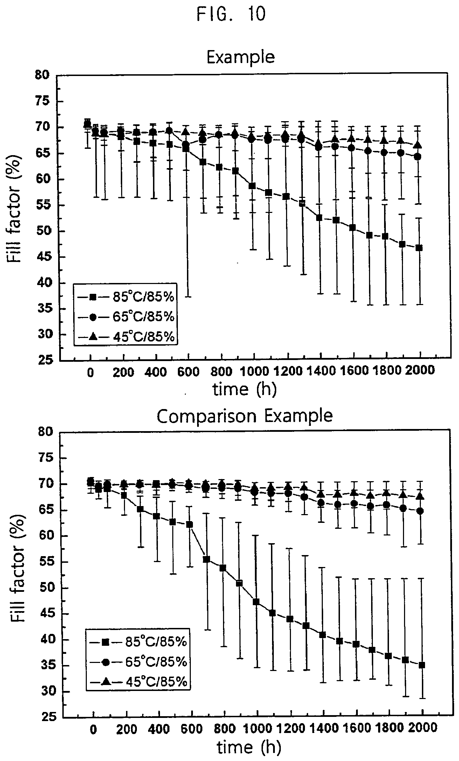

Referring to FIG. 10, it is noted that the degradation in the fill factor under the 85°C/85% condition is higher than those under 45°C/45% and 65°C/65% conditions. It is noted that the degradation in the fill factor of the photovoltaic cell is significantly prevented under the 85°C/85% condition when the anode for cathodic protection is attached (left), compared to when the anode for cathodic protection is not attached (right).

Serial resistances (mΩ) of the photovoltaic cells determined under the above-mentioned conditions are summarized in the following Table 5.

**Table 5**

|  | temp/ humidity | Initial value | 300 hr | 600 hr | 900 hr | 1200 hr | 1500 hr | 1800 hr | 2000 hr | rate of change |
|---|---|---|---|---|---|---|---|---|---|---|
| Exam. 13 | 85/85 | 10.20 | 11.60 | 12.27 | 14.43 | 16.86 | 20.00 | 22.15 | 24.92 | 144.3 % |
| Exam. 14 | 65/85 | 10.20 | 10.67 | 10.93 | 10.86 | 11.21 | 12.43 | 13.07 | 13.69 | 34.2% |
| Exam. 15 | 45/85 | 10.07 | 10.60 | 10.53 | 10.57 | 10.71 | 11.57 | 11.93 | 12.15 | 20.7% |
| Comp. Exam. 13 | 85/85 | 10.07 | 12.33 | 13.87 | 19.21 | 23.79 | 29.57 | 35.00 | 39.31 | 290.5 % |
| Comp. Exam. 14 | 65/85 | 9.93 | 10.20 | 10.27 | 10.36 | 11.00 | 12.43 | 13.07 | 13.54 | 36.3% |
| Comp. Exam. 15 | 45/85 | 10.07 | 10.07 | 10.13 | 10.14 | 10.29 | 11.64 | 12.00 | 12.08 | 20.0% |

Referring to Table 5, the serial resistance of the photovoltaic cell in Example 13, in which the anode for cathodic protection (sacrificial anode) was attached, was increased by 144.3% under 85/85 condition (85 °C temperature and 85% relative humidity), while that in Comparison Example 13, in which the anode for cathodic protection (sacrificial anode) was not attached, was increased by 290.5%. It is noted that the presence of the anode for cathodic protection has a significant impact in the serial resistance of the photovoltaic cell.

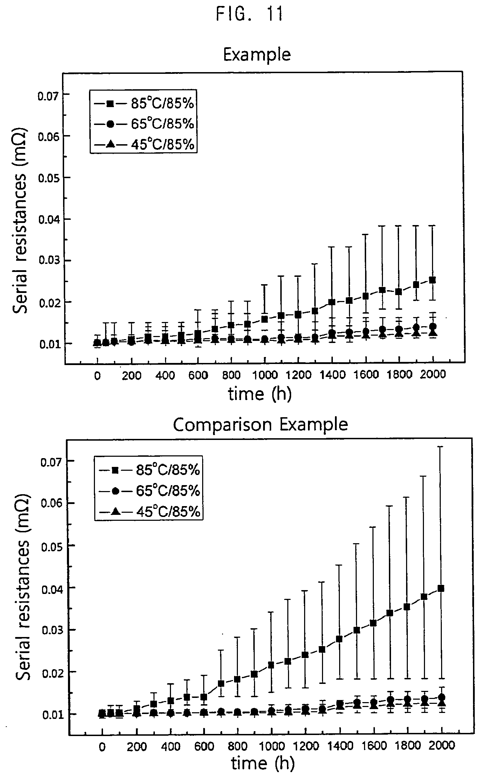

Referring to FIG. 11, it is noted that the serial resistance under the 85°C/85% condition is significantly increased than those under 45°C/45% and 65°C/65% conditions. It is noted that the increase of the serial resistance of the photovoltaic cell is significantly prevented under the 85°C/85% condition when the anode for cathodic protection is attached (left), compared to when the anode for cathodic protection is not attached (right).

### Examples 16-20

15 photovoltaic cell panels with and without an anode for cathodic protection in each were prepared as in Examples 1 to 15 and then salt-sprayed. 5wt.% of NaCl aqueous solution was used as salt water. Properties of the photovoltaic cells were determined at the temperature of 35°C after 48, 96 and 144 hours as in Examples 1 to 15.

Average value of each property of the photovoltaic cell is summarized in the following Table 6.

Table 6

| Properties | | Initial value | 48hr | 96hr | 144hr | rate of change(%) |
|---|---|---|---|---|---|---|
| Efficiency (%) | Example 16 | 13.68 | 9.52 | 5.46 | 4.10 | -70.06 |
| | Comparison Example 16 | 13.74 | 10.05 | 2.90 | 2.05 | -85.08 |
| open current voltage (V) | Example 17 | 0.564 | 0.556 | 0.560 | 0.564 | 0.03 |
| | Comparison Example 17 | 0.565 | 0.563 | 0.550 | 0.553 | -2.16 |
| short current (mA/cm$^2$) | Example 18 | 35.01 | 34.34 | 28.13 | 21.51 | -38.55 |
| | Comparison Example 18 | 35.10 | 34.48 | 18.00 | 11.69 | -66.70 |
| fill factor (%) | Example 19 | 69.3 | 49.7 | 33.4 | 32.0 | -53.82 |
| | Comparison Example 19 | 69.3 | 51.7 | 29.4 | 31.7 | -54.21 |
| serial resistance (m$\Omega$) | Example 20 | 10.3 | 23.6 | 43.3 | 59.3 | 475.73 |
| | Comparison Example 20 | 10.4 | 22.6 | 63.1 | 87.4 | 740.38 |

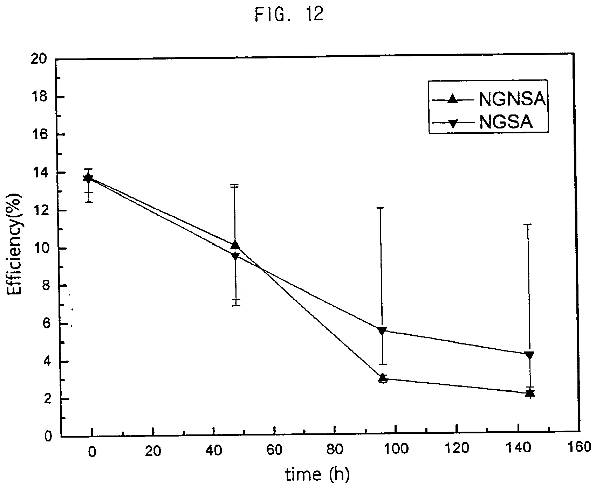

Referring to Table 6, changes in the efficiency of the photovoltaic cell in Examples, in which the anode for cathodic protection (sacrificial anode) was attached, were less than those in Comparison Examples, in which the anode for cathodic protection (sacrificial anode) was not attached. FIG. 12 illustrates graphs of changes in efficiencies of the photovoltaic cells with and without an anode for cathodic protection 144 hours later after salt spray (left: Example, right: Comparison Example).

The degradation in the open current voltage of the photovoltaic cells with the anode for cathodic protection is relatively less than that without the anode for cathodic protection.

The degradation in the short current of the photovoltaic cells with the anode for cathodic protection is significantly prevented.

The degradation in the fill factor of the photovoltaic cells with the anode for cathodic protection is relatively less than that without the anode for cathodic protection.

The serial resistance of the photovoltaic cells without the anode for cathodic protection is significantly increased, while such an increase is significantly prevented with the photovoltaic cells with the anode for cathodic protection.

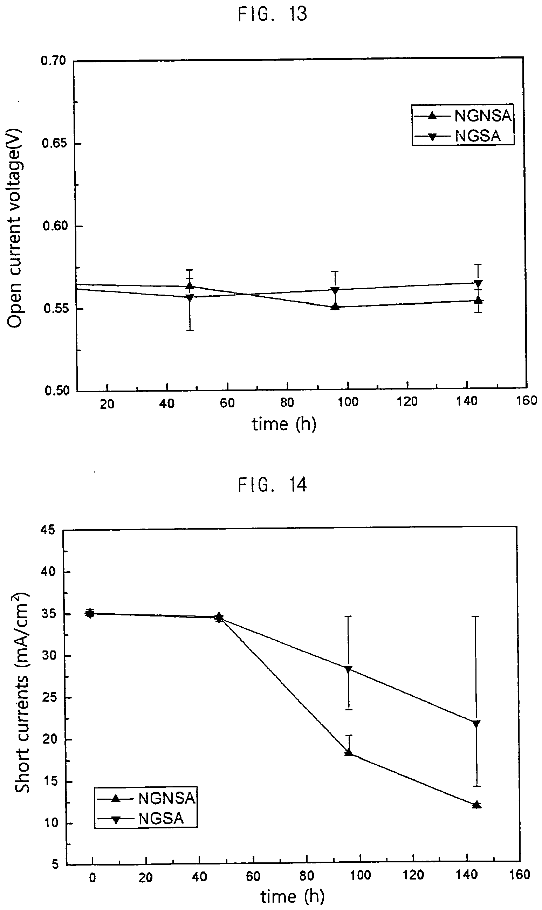

FIG. 13 illustrates graphs of characteristics of the photovoltaic cells with and without an anode for cathodic protection 144 hours later after salt spray (left: Example, right: Comparison Example)

As mentioned above, the according to the present invention, it may prevent an increase of serial resistance at a connective part between the ribbon and the cell and significantly reduce the degradation of efficiency by preventing the corrosion of the interconnector ribbon caused due to the external environment. In addition, the life of the photovoltaic module may be extended.

While it has been described with reference to particular embodiments, it is to be appreciated that various changes and modifications may be made by those skilled in the art without departing from the scope of the embodiment herein, as defined by the appended claims and their equivalents.

DESCRIPTION OF REFERENCE NUMBERALS

1: surface material (tempered glass)
2: filler (EVA)
3: photovoltaic cell

4: interconnector ribbon
5: surface material (tedra)
6 : bus ribbon
7 : an anode for cathodic protection

## Claims

1. A corrosion-resistant photovoltaic module, comprising:

    - at least one photovoltaic cell (3);
    - interconnector ribbon (4); and
    - at least one anode for cathodic protection (7) attached on the interconnector ribbon (4), wherein the anode for cathodic protection (7) is a metal having ionization tendency which is higher than that of the interconnector ribbon metal, wherein the anode for cathodic protection is positioned at the bus ribbon (6) or bus bar.

2. The corrosion-resistant photovoltaic module of claim 1, wherein the interconnector ribbon is at least one selected from the group consisting of a Cu electrode coated with Sn-Pb alloy, a Cu electrode coated with Sn, a Cu electrode coated with Sn-Pb-Ag alloy, a Cu electrode coated with Sn-Ag alloy, and a Cu electrode coated with Sn-Ag-Cu alloy.

3. The corrosion-resistant photovoltaic module of claim 2, wherein the anode for cathodic protection is at least one selected from the group consisting of Mg, Mg alloy, Al, Al alloy, Zn, and Zn alloy.

4. The corrosion-resistant photovoltaic module of claim 1, wherein size of the anode for cathodic protection is larger than that of the cathode.

## Patentansprüche

1. Korrosionsbeständiges Photovoltaikmodul, umfassend:

    - zumindest eine photovoltaische Zelle (3);
    - ein Verbindungsband (4); und
    - zumindest eine Anode für den kathodischen Schutz (7), die an dem Verbindungsband (4) befestigt ist,

    wobei die Anode für den kathodischen Schutz (7) ein Metall ist, das eine höhere Ionisierungstendenz aufweist als die des Metalls des Verbindungsbands, wobei die Anode für den kathodischen Schutz an dem Sammelband (6) oder der Sammelschiene angeordnet ist.

2. Korrosionsbeständiges Photovoltaikmodul nach Anspruch 1, wobei das Verbindungsband zumindest eines ist, das aus der Gruppe ausgewählt ist, die aus einer mit Sn-Pb-Legierung beschichteten Cu-Elektrode, einer mit Sn beschichteten Cu-Elektrode, einer mit Sn-Pb-Ag-Legierung beschichteten Cu-Elektrode, einer mit Sn-Ag-Legierung beschichteten Cu-Elektrode und einer mit Sn-Ag-Cu-Legierung beschichteten Cu-Elektrode besteht.

3. Korrosionsbeständiges Photovoltaikmodul nach Anspruch 2, wobei die Anode für den kathodischen Schutz zumindest eine ist, die aus der Gruppe ausgewählt ist, die aus Mg, Mg-Legierung, Al, Al-Legierung, Zn und Zn-Legierung besteht.

4. Korrosionsbeständiges Photovoltaikmodul nach Anspruch 1, wobei die Abmessungen der Anode für den kathodischen Schutz größer als die der Kathode sind.

## Revendications

1. Module photovoltaïque résistant à la corrosion, comprenant :

    - au moins une cellule photovoltaïque (3) ;
    - un ruban interconnecteur (4) ; et

- au moins une anode pour protection cathodique (7) fixée sur le ruban interconnecteur (4),

dans lequel l'anode pour protection cathodique (7) est un métal ayant une tendance à l'ionisation qui est supérieure à celle du métal du ruban interconnecteur, dans lequel l'anode pour protection cathodique est positionnée au niveau du ruban de bus (6) ou de la barre omnibus.

2. Module photovoltaïque résistant à la corrosion selon la revendication 1, dans lequel le ruban interconnecteur est au moins l'un choisi dans le groupe constitué d'une électrode de Cu revêtue avec un alliage Sn-Pb, une électrode de Cu revêtue avec Sn, une électrode de Cu revêtue avec un alliage Sn-Pb-Ag, une électrode de Cu revêtue avec un alliage Sn-Ag, et une électrode de Cu revêtue avec un alliage Sn-Ag-Cu.

3. Module photovoltaïque résistant à la corrosion selon la revendication 2, dans lequel l'anode pour protection cathodique est au moins l'un choisi dans le groupe constitué de Mg, un alliage de Mg, Al, un alliage de Al, Zn et un alliage de Zn.

4. Module photovoltaïque résistant à la corrosion selon la revendication 1, dans lequel la taille de l'anode pour protection cathodique est plus grande que celle de la cathode.

FIG. 1

FIG. 2

FIG. 3

FIG. 4

■ : position to attach a sacrificial anode

FIG. 5

1. Glass/EVA without a sacrificial anode
2. Screen print

Sacrificial metal (Zn)

1. Glass/EVA with a sacrificial anode
2. Screen print

FIG. 6

Initial

200 hours

300 hours

## FIG. 7

Example

Comparison Example

FIG. 8

Example

Comparison Example

## FIG. 9

### Example

### Comparison Example

FIG. 10

Example

Comparison Example

FIG. 11

Example

Comparison Example

FIG. 12

FIG. 13

FIG. 14

FIG. 15

FIG. 16

**EP 2 605 292 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 19947002010
- KR 20100134882
- US 20070144578 A1